# EUROPEAN PATENT APPLICATION

(11) **EP 4 026 726 A2**
(43) Date of publication of application: **13.07.2022**
(21) Application number: 22150548.0
(22) Date of filing: 07.01.2022
(51) Int. Cl.: B60L 53/18

(54) **ELECTRIC VEHICLE PORTABLE CHARGER ARC FAULT CIRCUIT INTERRUPTER**

(30) Priority: 08.01.2021 US 202163135200 P
(71) Applicant: Aptiv Technologies Limited, 14004 St. Michael (BB)
(72) Inventor: FRIEDRICH, Jacob, Pulaski, 16143 (US); KIKO, Jeffrey S., Kent, 44240 (US); RASCHILLA, Anthony, Girard, 44420 (US); ZHANG, Zhenyuan, Shanghai (CN); BIZON, Don E., Boardman, 44512 (US)
(74) Representative: Westphal, Mussgnug & Partner, Patentanwälte mbB

(57) **Abstract**

A portable electric vehicle supply equipment (EVSE) includes a first line and a second line, a current sensor, a microcontroller, and at least one protective relay. The current sensor is connected to monitor at least one of the first line or the second line and a current module is connected to sample the monitored current. The microcontroller is configured to detect arc faults in the first line and/or the second line based on the sampled current and to selectively open the protective relay in response to a detected arc fault.

## Description

### BACKGROUND

The present invention relates generally to electrical vehicle supply equipment (EVSE) and in particular to portable EVSE having arc fault detection.

An electric vehicle charging station, also called EV charging station, electric recharging point, charging point, charge point, electronic charging station (ECS), and electric vehicle supply equipment (EVSE), is a machine that supplies electric energy for the recharging of plug-in electric vehicles-including electric cars, neighborhood electric vehicles and plug-in hybrids. In some instances, the EVSE plugs includes a first cable connected to the power grid via a standard household wall outlet-socket and a second cable connected to the electric vehicle to supply charging power to the electric vehicle. Typically, the power supplied by the EVSE is alternating current (AC), wherein the vehicle includes an AC-to-DC converter for converting the AC power to DC power utilized to charge the battery.

In many applications, the EVSE is portable and is installed in a garage for use in charging the electric vehicle. Due to the nature of the use - for example, within a garage environment - damage may occur to one or more of the cables. It would be beneficial if the EVSE equipment could detect damage to the one or more cables and prevent the occurrence of faults.

### SUMMARY

According to one aspect, a portable electric vehicle supply equipment (EVSE) includes a first line and a second line, a current sensor, a microcontroller, and at least one protective relay. The current sensor is connected to monitor at least one of the first line or the second line and a current module is connected to sample the monitored current. The microcontroller is configured to detect arc faults in the first line and/or the second line based on the sampled current and to selectively open the protective relay in response to a detected arc fault.

### DETAILED DESCIRPTION

The present disclosure is directed to electric vehicle supply equipment (EVSE), and in particular to portable EVSE having arc fault circuit interruption (AFCI) protection. Portable EVSE typically includes a grid cord cable that connects to a wall socket/outlet, a coupler cable that interfaces with the electric vehicle (EV), and an EVSE module connected between the respective cables. Arc faults can occur in response to the cables - either the coupler cable or the grid cord cable - becoming damaged or ruptured. In some embodiments, the EVSE module includes a controller configured to monitor the charging of the EV. In some embodiments, monitoring includes monitoring the current on one or both of the conductors and analyzing the monitored current to detect arc faults. In some embodiments, arc fault detection requires high-frequency monitoring of the delivered current. In response to a detected arc fault, the controller opens one or more protective relays located in the EVSE module to prevent the flow of current. In addition, the controller may generate an alert or warning indicating that an arc fault has been detected.

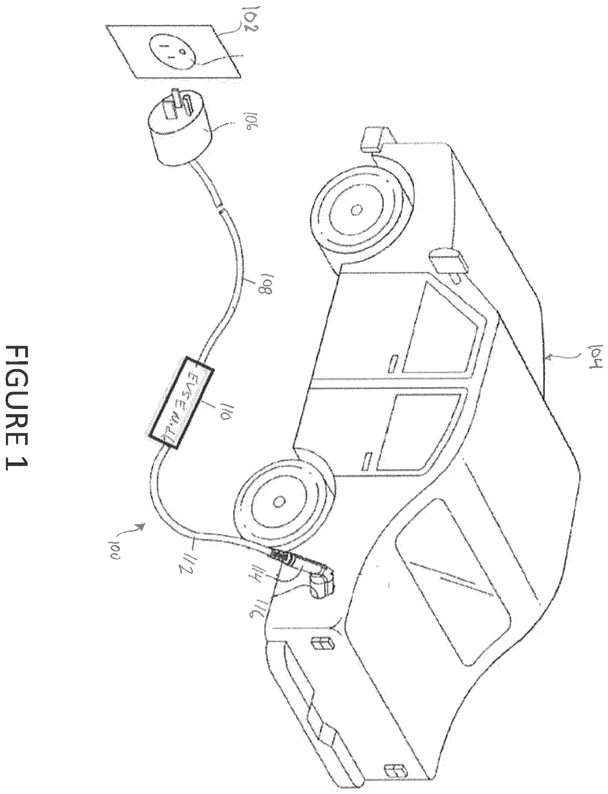

Figure 1 is a diagram of an electric vehicle supply equipment (EVSE) 100 configured to provide charging power from a wall outlet/socket 102 to an electric vehicle (EV) 104. The EVSE 100 includes a socket 106, a grid cord cable 108, an EVSE module 110, a coupler cable 112, and an EV port 114 configured to mate with an EV socket 116. In some embodiments, EVSE 100 is portable, and may be utilized to charge EV 104 from a typical wall outlet/socket 102. For example, EVSE 100 may be sold with EV 100 (or purchased separately) and utilized by the user to charge the EV 100 at home - typically within a garage. This type of environment may result in damage to one or both of the grid cord cable 108 and/or coupler cable 112. In particular, both the grid cord cable 108 and/or coupler cable 112 include inner conductors surrounded by an outer, insulative jacket. Damage to the outer jacket - for example as a result of the cords being run over - may result in exposure of the inner conductors that results in series and/or parallel arc faults. In some applications, the wall outlet/socket 102 may be equipped with arc fault detection (e.g., arc fault circuit interrupter (AFCI)), but in many applications this is not the case. In some embodiments, EVSE module 110 includes an arc fault circuit interrupter (AFCI) protective device and protective relays selectively opened in response to a detected arc fault. In addition, in some embodiments the EVSE module 110 may include other protective devices, such as residual current devices (RCD) to protect from leakage currents.

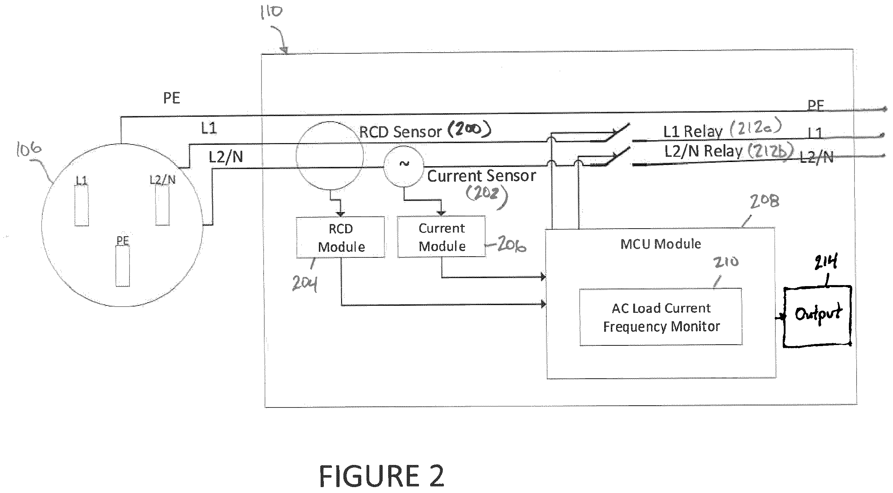

Figure 2 is a simplified block diagram of EVSE module 110. In this embodiment, the EVSE includes a protective earth (PE) conductor, a first line (L1) conductor, and a second line (L2/N) conductor. In some embodiments, the EVSE module 110 includes a residual current device (RCD) sensor 200, a current sensor 202, a RCD module 204, a current module 206, a microcontroller 208 that includes AC load current frequency monitoring 210, and first and second protective relays 212a, 212 connected on the first line L1 and second line L2/N, respectively.

In some embodiments, RCD sensor 200 is a current transformer that monitors for imbalances between the first line L1 and the second line L2/N. During normal operation, the current flowing on the first line L1 is approximately equal to the current flowing (in the opposite direction) on the second line L2/N. The output of the RCD sensor 200 is approximately zero because the difference between the currents on the respective lines is approximately zero. An undesirable residual or leakage current causes an imbalance in the respective line currents that results in generation of a voltage representative of the current differential. RCD module 204 monitors the voltage provided by the RCD sensor 200 and generates a trip in response to the voltage exceeding a threshold level. The trip or response is provided to the microcontroller module 208, which in turn generates control signals to open or trip the protective relays 212a, 212b, preventing additional current from flowing through the first line L1 and second line L2/N.

In addition, current sensor 202 monitors current through one or both of the lines. In the embodiment shown in Figure 1, current sensor 202 monitors current through the second line L2/N, but in other embodiments additional current sensors may be utilized to monitor the current in the first line L1, the second line L2/N, or both the first line L1 and the second line L2/N. Current module 206 samples the monitored current and converts the monitored currents to a digital value that is provided to the microcontroller 208. The monitored current may be utilized for both overcurrent detection as well as for arc fault detection. Overcurrent detection requires comparison of the monitored current to a threshold value (in some embodiments over a period of time). The comparison may be done by the current module 206 or by the microcontroller 208. In response to an overcurrent condition, the microcontroller 208 opens one or both of the protective relays 212a, 212b. In addition, to provide arc fault circuit interruption (AFCI) functionality, the current module 206 samples the monitored current at a given frequency. In some embodiments, arc faults are characterized by a high-frequency signature which requires sampling the monitored current at the required frequency (e.g., 100 kHz). In some embodiments, current module 206 samples the monitored current for a period of time (e.g., several milliseconds). The monitored AC current is provided to microcontroller 208 for storage and analysis.

In some embodiments, microcontroller 208 includes an AC load current frequency monitor that analyzes monitored current to detect series and/or parallel arc faults. In some embodiments, analysis of the monitored current includes comparing the monitored current to signature signals representing a series and/or parallel arc fault. In other embodiments, other types of arc fault analysis may be utilized to detect series and/or parallel arc faults. In response to a detected arc fault condition, the microcontroller 208 generates control signals to open the first and second relays 212a, 212b to prevent the flow of current to the electric vehicle. In some embodiments, in addition to generating a control signal to open the protective relays 212a, 212b, the microcontroller 208 generates an output (e.g., visual, audio, etc.) alerting an operator to the type of fault detected (e.g., arc fault versus RCD). For example, in response to a detected fault condition the microcontroller 208 instructs output 214 to generate an audio and/or visual output indicating the detected fault condition. In some embodiments a visual output may include a light indicating either by location or color the presence and/or type of fault detected. Similarly, an audio output may include an audible warning indicating the presence and/or type of fault detected.

A benefit of this approach is that the portable EVSE provides arc fault circuit interrupt (AFCI) capability regardless of the type of wall socket/plug to which the EVSE is connected. In addition, because EVSEs are typically required to include RCD sensing and overcurrent sensing, the overhead for implementing arc fault detection and interruption is very low.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A portable electric vehicle supply equipment (EVSE) (100) comprising:
a first line L1);
a second line (L2/N);
a current sensor (202) connected to monitor current flowing in at least one of the first line (L1) or the second line (L2/N);
a current module (206) connected to sample the monitored current;
a microcontroller (208) configured to detect arc faults based on the sampled current; and
at least one protective relay (212a, 212b) connected to the first line (L1) or the second line (L2/N), wherein the microcontroller (208) opens the protective relay (212a, 212b) in response to a detected arc fault.

2. The portable EVSE (100) of claim 1, wherein the current module (206) samples the monitored current at a frequency equal to or greater than a threshold frequency.

3. The portable EVSE (100) of claim 2, wherein the threshold frequency is equal to approximately 100 kilo-hertz (KHz).

4. The portable EVSE (100) of any one of the preceding claims, wherein the microcontroller (208) compares the sampled current to one or more signature signals representing series and/or parallel arc faults to detect arc faults.

5. The portable EVSE (100) of any one of the preceding claims, further including:
a residual current device (RCD) module (204) configured to generate a trip signal in response to a detected current differential between the first line (L1) and the second line (L2/N) exceeding a threshold value.

6. The portable EVSE (100) of claim 5, further including:
a residual current device (RCD) sensor (200) configured to monitor current in the first line (L1) and the second line (L2/N) and to generate a voltage representative of a current differential between the first line (L1) and the second line (L2/N), wherein the RCD module (204) receives the voltage representative of the current differential from the RCD sensor (200) generates the trip signal provided to the microcontroller (208) in response to the voltage exceeding a threshold level.

7. The portable EVSE (100) of claim 5 or 6, wherein the microcontroller (208) opens the protective relay (212a, 212b) in response to the trip signal generated by the RCD module 204.

8. The portable EVSE (100) of any one of the preceding claims, further including:
an output device (214) that generates an output in response to a detected arc fault.

9. The portable EVSE (100) of claim 8, wherein the output device (214) generates an audible output, a visual output, or a combination of audible and visual outputs in response to a detected arc fault.

10. The portable EVSE (100) of any one of the preceding claims, wherein the microcontroller (208) is configured to detect overcurrent faults based on the sampled current exceeding a threshold overcurrent threshold.

11. The portable EVSE (100) of any one of the preceding claims, further including:
a socket (106) configured to connect a wall outlet (102), wherein a first end of the first line (L1) and a first end of the second line (L2/N) terminate at the socket (106); and
an electric vehicle (EV) port (114) configured to connect to connect to an EV socket (116), wherein a second end of the first line (L1) and a second end of the second line (L2/N) terminate at the EV port (114), wherein the at least one protective relay (212a, 212b) is connected to either the first line (L1) or the second line (L2/N) between the first end and the second end, and wherein the current sensor (202) is connected to at least one of the first line (L1) or the second line (L2/N) between the first end and the second end.

12. An electric vehicle supply equipment (EVSE) module (110) comprising:
a current sensor (202) connected to monitor current flowing in at least one of a first line (L1) or a second line (L2/N);
a current module (206) configured to sample the monitored current at a selected sampling rate;
a microcontroller (208) configured to detect arc faults based on the sampled current;
a residual current device (RCD) module (204) configured to generate a trip signal provided to the microcontroller (208) in response to a detected current differential between the first line (L1) and the second line (L2/N) exceeding a threshold value; and
at least one protective relay (212a, 212b) connected to the first line (L1) or the second line (L2/N), wherein the microcontroller (208) opens the protective relay (212a, 212b) in response to a detected arc fault or detected current differential.

13. The EVSE module (110) of claim 12, further including:
a residual current device (RCD) sensor (200) configured to monitor current in the first line (L1) and the second line (L2/N) and to generate a voltage representative of a current differential between the first line (L1) and the second line (L2/N), wherein the RCD module (204) receives the voltage representative of the current differential from the RCD sensor (200) generates the trip signal provided to the microcontroller (208) in response to the voltage exceeding the threshold level.

14. The EVSE module (110) of claim 12 or 13, wherein the current module (206) samples the monitored current at a frequency equal to or greater than a threshold frequency.

15. The EVSE module (110) of any one of claims 12 to 14, wherein the microcontroller (208) compares the sampled current to one or more signature signals representing series and/or parallel arc faults to detect arc faults.
